# EUROPEAN PATENT SPECIFICATION

(11) **EP 1 457 861 B1**
(45) Date of publication and mention of the grant of the patent: **27.09.2006**
(21) Application number: 03005541.2
(22) Date of filing: 11.03.2003
(51) Int. Cl.: G06F 1/10

(54) **Topology for providing clock signals to multiple circuit units on a circuit module**
Topologie zur Verfügungstellung von Taktsignalen an mehrere Schaltungseinheiten auf einem Schaltungsmodul
Topologie pour fournir des signaux d'horloge à plusieurs unités de circuit sur un module de circuit

(43) Date of publication of application: 15.09.2004
(73) Proprietor: Infineon Technologies AG, 81669 München (DE)
(72) Inventor: Kuzmenka, Maksim, 81829 München (DE); Chennupati, Siva RaghuRam, 82110 Germering (DE); Bacha, Abdallah, 80802 Munich (DE); Muff, Simon, 85635 Höhenkrichen (DE)
(74) Representative: Stöckeler, Ferdinand

(56) References cited:
- JP-A- 7 084 665
- US-A- 6 081 145
- US-A1- 2001 050 856
- "NESTED PHASE-LOCK LOOPS FOR BOARD LEVEL CLOCKING" IBM TECHNICAL DISCLOSURE BULLETIN, IBM CORP. NEW YORK, US, vol. 37, no. 6A, 1 June 1994 (1994-06-01), pages 349-351, XP000455801 ISSN: 0018-8689

## Description

The present invention relates to a topology for providing clock signals to multiple circuit units on a circuit module and, in particular, to a topology which is appropriate to distribute clock signals to multiple memory chips located on a memory module.

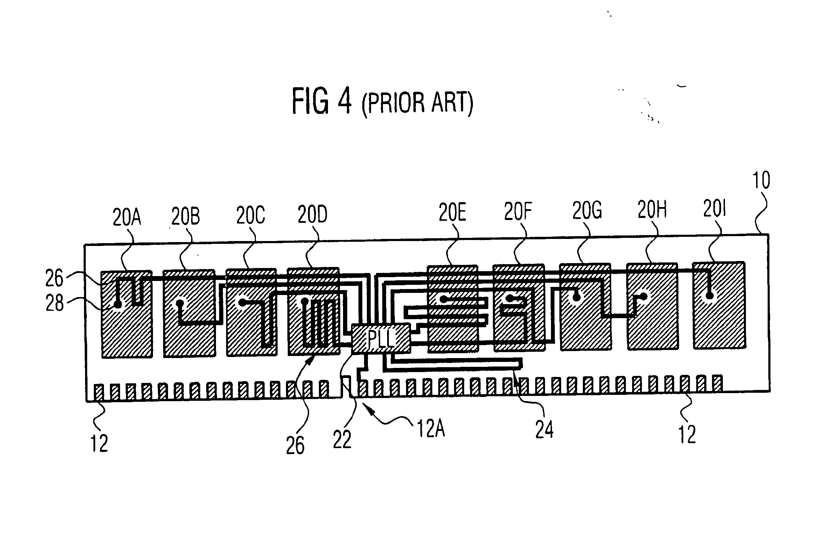

An existing clock topology for providing a clock signal to multiple memory chips is shown in Fig. 4. The clock topology shown in Fig. 4 is implemented in existing DDR1 and DDR2 memory modules.

The existing memory module comprises a circuit board 10 provided with multiple edge connectors 12, one of them being a clock input 12a. The circuit board 10 can be inserted with the edge connectors into a mating plug connector provided on a motherboard such that the clock input 12a is connected to an external clock line so that an external clock signal can be received at the clock input 12a.

Multiple memory chips 20a to 20i are provided on the memory module circuit board 10. In addition, a phase locked loop unit 22 (PLL unit) in the form of a PLL chip is provided on the circuit board 10. A PLL clock input of the PLL 22 is connected to the clock input 12a. A PLL feedback loop 24 is connected between a PLL feedback loop output and a PLL feedback loop input of the PLL unit. Moreover, the PLL unit 22 comprises multiple PLL clock outputs each of which is connected to one or more memory chips via corresponding clock lines 26. The clock lines 26 are connected to respective memory chip clock inputs of the memory chips 20a to 20i.

The PLL unit 22 provides an internal clock signal via the clock lines 26 to the memory chips 20a to 20i based on the external clock signal received via the clock input 12a. In the ideal case, the PLL unit 22 provides the internal clock signal with a zero phase shift to all memory chips 20a to 20i on the memory module which can be implemented as a DIMM module. Moreover, in the ideal case, the PLL unit 22 provides a zero delay from the PLL clock input to the respective clock inputs 28 of the memory chips, i.e. the DRAM chips.

The topology shown in Fig. 4 has two main disadvantages. The first disadvantage is that all clock lines 26, i.e. all clock traces, must be matched with respect to length to the longest one so that the delay provided by the line length can be compensated for by accordingly adapting the length of the PLL feedback loop 24. As a consequence it is necessary to provide the clock traces 26 adjacent to the PLL chip 22 with a "meander" or "serpentine" structure as it is shown in Fig. 4. Such structures occupy much area of the printed circuit board 10. As a result, in most cases, clock signal routing requires a separate layer of a multi-layer printed circuit board. Moreover, matching the length of all clock traces to the longest one results in a performance which is inferior when compared to a performance which could be obtained when making use of shorter clock traces.

The other main disadvantage of the topology of the clock traces shown in Fig. 4 is that most of the existing PLL chips designed for memory applications have ten clock outputs, i.e. ten pairs of clock outputs in case of a differential signal transmission. In case of a memory module having 36 memory chips (and 1 or 2 memory registers), load is four DRAM chips per PLL clock output. This reduces the signal quality with respect to the slew rate at high frequencies so that operation at frequencies of more than 166 MHz appears to be problematic. PLL chips having 18 to 20 pairs of clock outputs could, in principle, solve this problem, but unfortunately such PLL chips do not exist on the market. Moreover, making using of PLLs with 18 to 20 pairs of clock outputs would increase the problem concerning the trace lengths indicated above.

US 2001/050856 A1 relates to a memory module having a number of memory chips. A first PLL and a second PLL are provided on a memory module board of the memory module and are connected to a clock input. The first PLL provides a clock used to input data to the memory chips, while the second PLL provides a clock used to output data from the memory chips.

In "Nested Phase-Lock Loops for Board Level Clocking", IBM Technical Disclosure Bulletin, IBM Corp. New York, US, vol. 37, no. 6A, June 1, 1994, pages 349 to 351, nested phase-lock loops for board level clocking are described. A clock source is connected to two PLLs. One PLL is for providing a clock signal to first chips, while the other PLL is for providing a clock signal to second chips.

US 6,081,145 relates to a semiconductor integrated circuit device having a plurality of functional blocks. Each of the functional blocks comprises a delay-locked loop for outputting a clock signal, at least one wiring portion for receiving the clock signal at one end thereof, and at least one load circuit for receiving the clock signal from the DLL circuit via the wiring portion. The DLL circuit receives a reference clock signal and a wiring portion and outputs the clock signal so that the phase difference between the reference clock signal and the second clock signal is a predetermined value.

It is the object of the present invention to provide a memory module having a topology for providing clock signals to multiple memory chips on the memory module which permits increased clock frequencies when compared to prior art solutions.

This object is achieved by a memory module according to claim 1.

The present invention is based on the finding that the above problems associated with prior art solutions can be solved or diminished by making use of more than one PLL unit per circuit module. By making use of multiple PLL units, the line length between the PLL unit and the respective circuit units can be reduced. Moreover, the load of each PLL clock output can be reduced when making use of existing PLL chips having ten PLL clock outputs, for example.

In preferred embodiments of the invention, the circuit module is a memory module, a DIMM module, for example, and the circuit modules are memory chips, DRAM chips, for example.

According to the present invention, the PLL clock input of the plurality of PLL units can be connected to the same clock input on the memory module board or to different clock inputs on the memory module board. Each of the PLL units can have associated therewith an individual feedback loop. Alternatively, a common feedback loop may be provided for two or more PLL units in that an internal clock signal is output onto the common feedback loop by one PLL unit, the feedback loop branches into multiple feedback loop branches and respective versions of the clock signal transmitted via the respective branches of the feedback loop are received by two or more PLL units.

In the following, preferred embodiments of the invention are described making reference to the accompanying drawings. In the different drawings, elements corresponding to each other are provided with the same reference numerals wherein repeated separate description of the same elements is omitted.
Figures 1a and 1b show a first embodiment of a memory module according to the invention;
Figures 2a and 2b show a second embodiment of a memory module according to the invention;
Figures 3a and 3b show a third embodiment of a memory module according to the invention; and
Fig. 4 shows a prior art memory module.

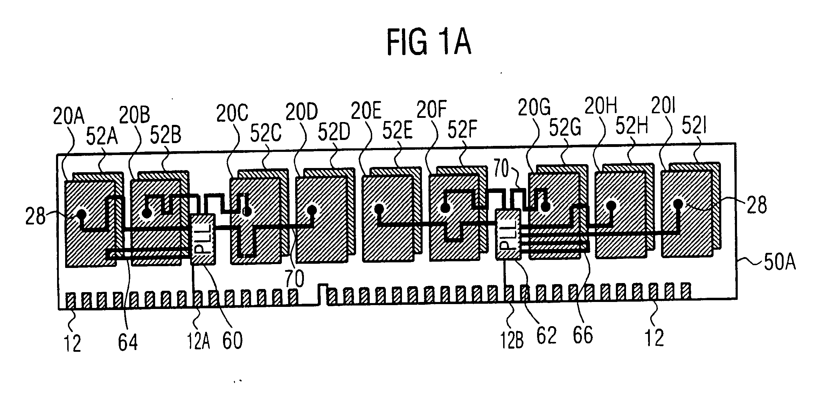

As it is shown in Fig. 1a, a memory module according to the first embodiment of the invention comprises a module circuit board 50a. Multiple circuit chips 20a to 20i are provided on one surface of the module circuit board 50a. To indicate that a corresponding number of memory chips can also be placed on the backside of the module circuit board 50a, backside chips 52a to 52i are shown in Fig. 1a offset with respect to the memory chips 20a to 20i. The memory chips 20a to 20i and 52 can be conventional DRAM chips used in existing DDR1 and DDR2 memory topologies.

The memory module shown in Fig. 1a is in the form of a DIMM module and has multiple edge connectors 12. The module circuit board 50a is adapted to be inserted into a mating plug connector on a motherboard so that the edge connectors 12 make contact to mating counterparts of the plug connector. As indicated in Fig. 1a, the edge connectors include two board clock inputs 12a and 12b. The board clock inputs 12a and 12b will be coupled to clock lines on the motherboard when the memory module is inserted into the mating plug connector of the motherboard.

Moreover, a first PLL unit 60 and a second PLL unit 62 are provided on the circuit board 50a. The PLL units 60 and 62 can be formed by existing PLL chips having ten clock output ports, for example. A PLL clock input of the first PLL unit 60 is connected to the clock input 12a, while a PLL clock input of the second PLL unit 62 is connected to the clock input 12b. A first feedback loop 64 is provided for the first PLL unit and a second feedback loop 66 is provided for the second PLL unit 62.

Respective PLL clock outputs of the first PLL unit 60 are connected to clock inputs 28 of the memory chips 20a, 20b, 20c and 20d via clock traces 70. In addition, each of the clock PLL outputs is connected to the clock inputs of two memory chips, namely 20a and 52a, 20b and 52b, and so on. Respective clock outputs of the second PLL unit 62 are connected to clock inputs 28 of the memory chips 20e to 20i and 52e to 52i via associated clock traces 70.

The PLL units 60 and 62 receive an external clock signal via the clock inputs 12a and 12b and provide an internal clock signal based on the external clock signal to the memory chips. To be more specific, the first PLL unit 60 provides the internal clock signal to the memory chips 20a to 20d and 52a to 52d, while the second PLL unit 62 provides the internal clock signal to the memory chips 20e to 20i and 52e to 52i.

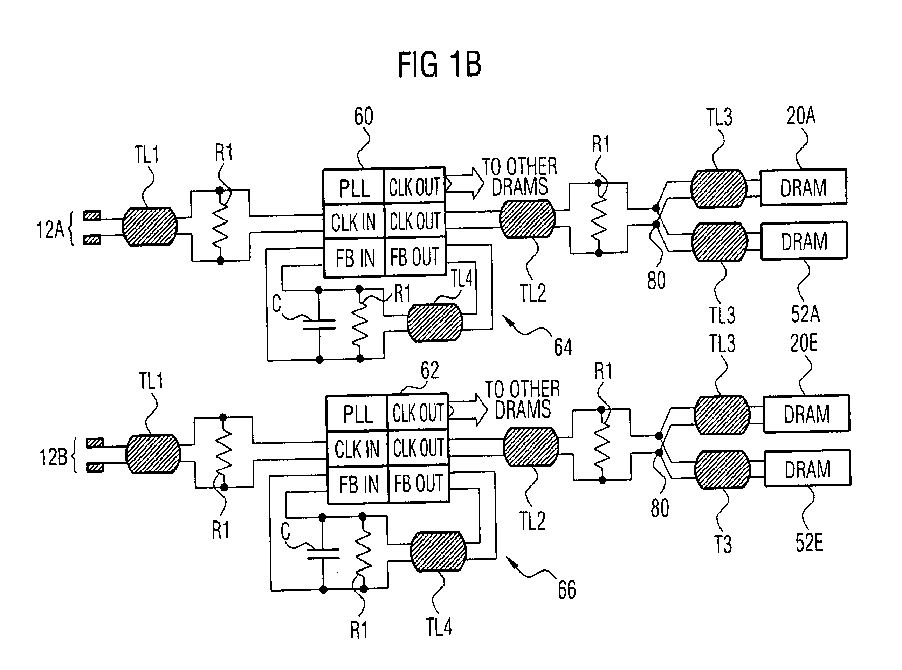

As can be seen in Fig. 1a, the trace lengths of the respective clock traces 70 can be reduced when compared to the trace lengths of the prior art module shown in Fig. 4 by making use of two PLL units rather than a single PLL unit as in Fig. 1.

For the purposes of a clear representation, all clock traces are shown in Figures 1a, 2a, 3a and 4 like single ended traces, while, in preferred embodiments of the invention, same are formed by differential traces, as will become clear from the description of Figures 1b, 2b and 3b.

Fig. 1b shows a more detailed diagram of the memory module of Fig. 1a. In Fig. 1b, the clock inputs 12a and 12b are shown as differential clock inputs. The clock inputs 12a and 12b are connected to the first PLL unit 60 and the second PLL unit 62, respectively, via respective first transmission lines TL1. In order to prevent reflections at the input of the respective PLL unit, respective termination resistors R1 are connected between the differential traces of the transmission line connecting the clock input 12a to the first PLL unit 60 and the clock input 12b to the second PLL unit 62. The termination resistors are provided adjacent the respective PLL unit.

Each of the PLL units 60 and 62 comprises a clock input CLKin, multiple clock outputs CLKout, a feedback input FBin and a feedback output FBout. The respective PLL clock input CLKin is connected to the transmission lines TL1 respectively, to receive an external clock signal applied to the clock input 12a and 12b, respectively.

Each PLL clock output CLKout is connected to two memory chips via respective second transmission lines TL2 and third transmission lines TL3. Again, termination resistors R1 are provided in order to prevent reflections. In a practical implementation, the length of the second transmission lines TL2 is much longer than the length of the third transmission lines TL3. Thus, when considering reflections, the lengths of the third transmission lines TL3 can be neglected and the respective termination resistor R1 can be provided preceding a respective branching point 80 at which the transmission line TL2 splits up into two separate lines TL3 each of which is connected to a respective memory chip.

For the purposes of a clear representation, Fig. 1b only shows the connection of one PLL clock output to both DRAM chips 20a and 52a with respect to the PLL unit 60 and the connection of one PLL clock output to the DRAM chips 20e and 52e with respect to the PLL unit 62. It is clear for a man skilled in the art, that each of the PLL units comprises a number of PLL clock outputs appropriate to provide a connection to all memory chips of the memory module, wherein each clock output is connected to two memory chips in the manner described above with respect to memory chips 20a, 52a, 20e and 52e.

As it is shown in Fig. 1b, the first feedback loop 64 is connected between the feedback loop output FBout and the feedback loop input FBin of the PLL unit 60, while the second feedback loop 66 is connected between the feedback loop output and the feedback loop input of the second PLL unit 62. The feedback loops 64 and 66 are designed to show a behavior between the feedback loop output and the feedback loop input of the respective PLL unit similar to the behavior of the respective clock traces between the PLL clock outputs of the PLL units and the clock inputs of the memory chips. To this end, the feedback loops are designed with a structure similar to that of the clock traces and include a respective fourth transmission line TL4 and a respective termination resistor R1. The fourth transmission lines can have the same line length as the line length of the clock trace between the PLL unit and the memory chips. In order to take into account the fact that two memory chips are connected to each PLL clock output, it may be necessary to provide an additional capacitor C in the feedback loops. This capacitor C represents a "virtual" second load of the respective feedback loop in addition to the feedback loop input of the respective PLL unit so that the load conditions of the clock traces and the feedback loops are equalized and the feedback loop shows a behavior similar to that of the clock traces.

As it is known in the art, the PLL units 60 and 62 output the internal clock signal to the feedback loops 64 and 66, respectively via the feedback loop output FBout. Thus, one of the normal PLL clock outputs may be used as the feedback loop output. The internal clock signal transmitted over the feedback loop is received at the feedback loop input FBin. The PLL unit controls the frequency of the internal clock signal based on a comparison of the external clock signal applied to the PLL clock input CLKin and the version of the internal clock signal received at the feedback loop input FBin. To be more specific, the phase of external clock signal applied to the PLL clock input and the phase of the internal clock signal transmitted over the feedback loop are compared and the internal clock signal output from the PLL clock output is controlled such that, in the ideal case, phase shift to all memory chips on the memory module is zero and delay from the PLL clock input to the memory chip clock inputs is, in the ideal case, zero.

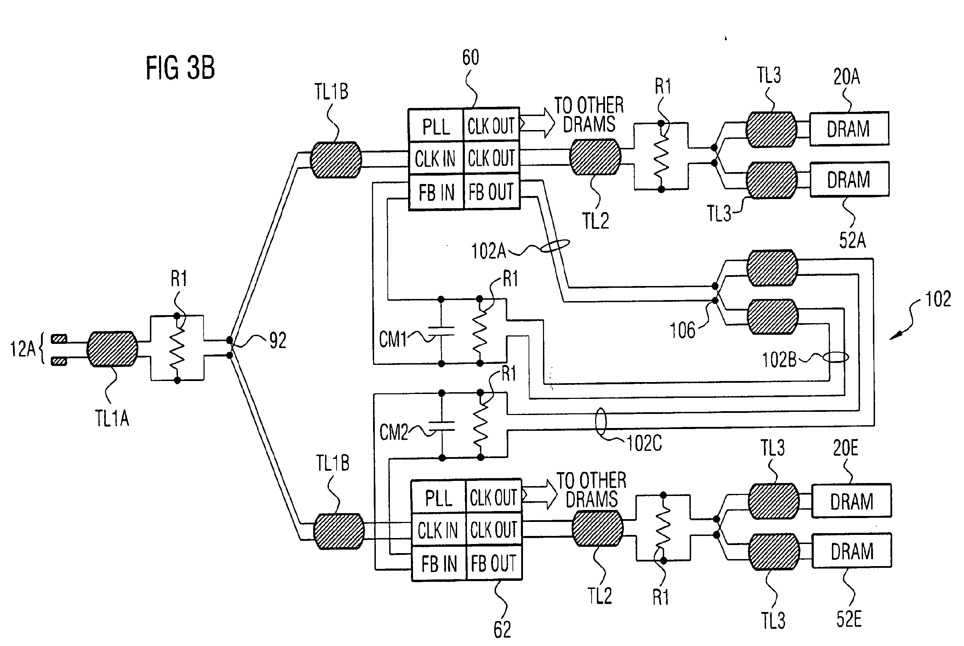

According to the embodiment shown in Figures 1a and 1b two independent PLL units are used. To be more specific, each PLL unit has its own clock input 12a and 12b, respectively, and its own feedback loop 64 and 66, respectively, on the circuit board. This solution has the advantage of a reduced length of nets between the PLL units and the memory chips and the advantage of a reduced area occupied by such nets. However, in the embodiment shown in Fig. 1a, two separate clock inputs are provided on the circuit board. Alternatively, one single clock input could be provided on the circuit board as will be described later herein making reference to Fig. 3b. Moreover, according to the above embodiment, each individual PLL chip may have a phase error and, in the worst case, the phase error between the right and the left part of the memory module will be doubled.

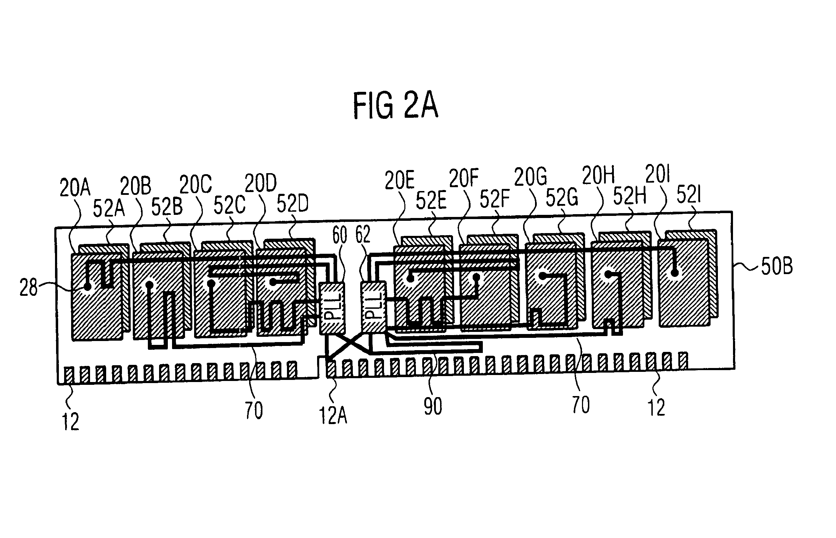

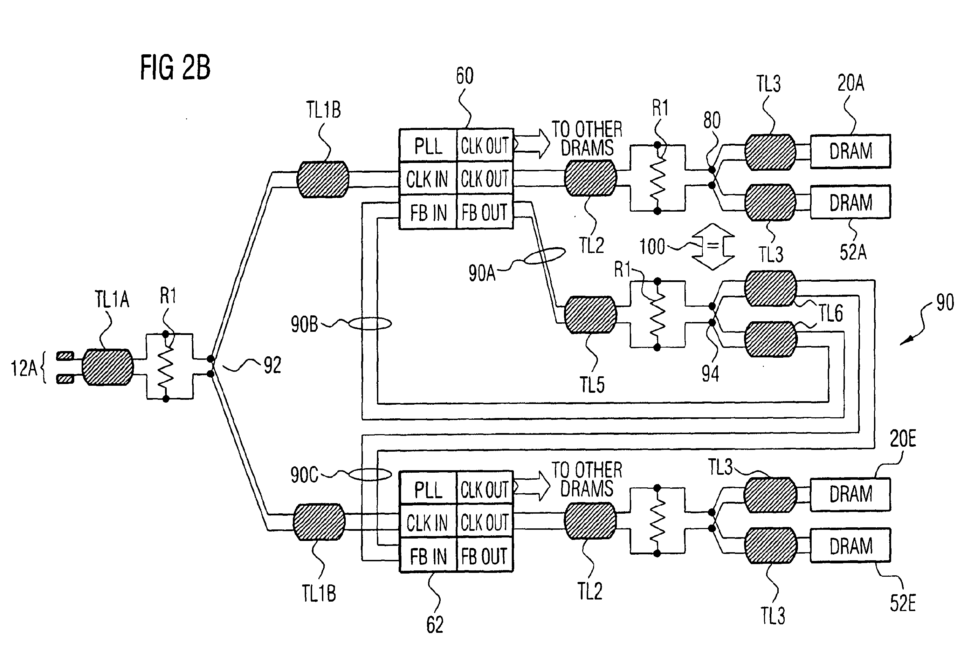

In Figures 2a and 2b, a further embodiment of the present invention is shown in the case of which two PLL units 60 and 62 share one feedback loop. Moreover, both PLL units 60 and 62 are connected to the same clock input 12a on the module circuit board 50b.

As can be seen from Fig. 2b, the PLL units 60 and 62 are connected to the same board clock input 12a via a first portion TL1a of the first transmission line and second portions TL1b of the first transmission line. In this situation, a termination resistor R1 is connected between the first portion TL1a and a branching point 92 at which the first portion TL1a branches into the two second portions TL1b. The shared feedback loop 90 comprises a common feedback loop portion 90a, a branching point 94, a first feedback loop branch 90b and a second feedback loop branch 90c. The common feedback loop portion 90a is connected to the feedback loop output FBout of the PLL unit 60 and comprises a transmission line TL5 and a termination resistor R1. At the branching point, the common portion 90a branches into the first feedback loop branch 90b which is connected to the feedback loop input FBin of the PLL unit 60, and into the second feedback loop branch 90c, which is connected to the feedback loop input FBin of the PLL unit 62. Each of the feedback loop branches comprises a transmission line TL6.

As it is indicated by an indication arrow 100, in the particular embodiment shown, the number of feedback loop branches into which the common feedback loop portion branches corresponds to the number of memory chips connected to each clock output CLKout. This may be helpful in designing the load of the FBout to be similar to the load of CLKout.

The embodiment shown in Figures 2a and 2b removes a difference in static phase offset between the PLL units 60 and 62. To this end, the PLL units 60 and 62 must be placed close to each other on the circuit board 50b in order to keep a net structure of the feedback loop similar to the clock traces between the PLL units and the memory chips. However, by placing the PLL chips close to each other, the line lengths required are increased when compared to the embodiment shown in Figures 1a and 1b. By making use of a shared feedback loop, the PLL unit 62 does not need a separate feedback loop output, so that that output indicated in Fig. 2b as a feedback loop output could be used as a normal clock output.

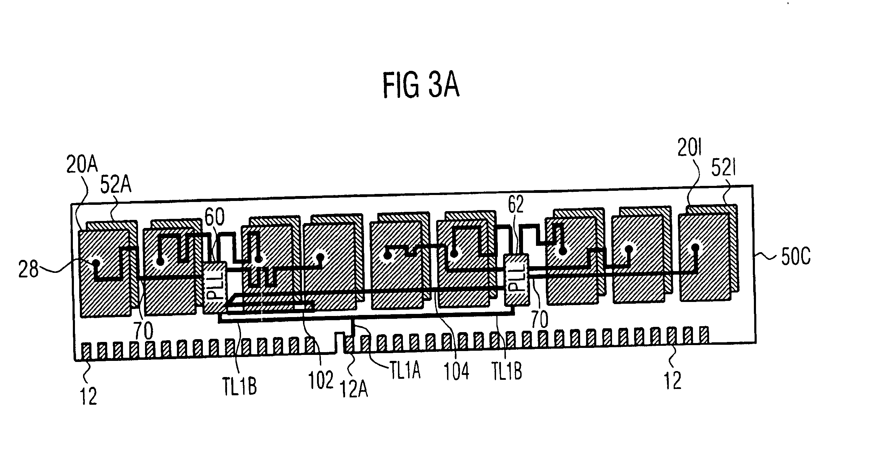

A further embodiment of the present invention making use of a shared feedback loop and providing for reduced clock trace lengths is shown in Figures 3a and 3b. As in Fig. 1, the PLL units are placed in an unsymmetrical manner spaced apart from each other between the circuit chips 20a to 20i. The clock inputs of the PLL units 60 and 62 are connected to the same board clock input 12a. Both PLL units 60 and 62 make use of a shared feedback loop 102, wherein, due to the spatial distance between the PLL units, the structure of the PLL loop is different from the structure of the clock traces between the PLL units and the memory chips. An indication for this is given in Fig. 3a by line 104.

As can be seen in Fig. 3b, the clock input of the PLL units 60 and 62 are connected to the common circuit board clock input 12a via a first portion of a first transmission line TL1a and respective second portions of the first transmission line TL1b. A termination resistor is connected between the differential lines of the first portion TL1a preceding a branching point 92. The lengths of the transmission lines TL1a and TL1b depend on the positions of the PLL units on the module circuit board.

The shared feedback loop 102 comprises a common feedback loop portion 102a, a branching point 106, a first feedback loop branch 102b and a second feedback loop branch 102c. The first feedback loop 102b and the second feedback loop branch 102c are similar to each other. The connection of the elements of Fig. 3b is similar to that described with respect to Fig. 2b. However, in case of Fig. 3b, the feedback loops associated to each of the PLL units have a different structure when compared to the structure of the traces between the PLL units and the memory chips. The feedback loop associated to the PLL unit 60 is the feedback loop comprising the common portion 102a and the first branch 102b. The feedback loop associated to the PLL unit 62 is the feedback loop comprising the common portion 102a and the second branch 102c. Thus, in the embodiment shown in Fig. 3, additional elements have to be connected into the feedback loop in order to obtain an electrical behavior similar to that of the clock traces between the PLL units and the memory chips. In the embodiment shown in Fig. 3b, this is achieved by connecting matching capacitors C_{M1} and C_{M2} between the differential lines of the feedback loops parallel to termination resistors R1. In this embodiment, the position of the PLL units is optimized for a shortest possible PLL to DRAM routing.

Also not explicitly stated above, it is clear that the length of the respective clock traces between the PLL units and the different memory chips has to be adapted to the length of the longest clock trace for each embodiment. Moreover, it is clear for a man of ordinary skill that termination resistors could be positioned at other or additional positions in order to achieve the required performance with respect to preventing reflections.

### List of reference numbers

- 10: Circuit board
- 12: Edge connectors
- 12a, 12b: Clock inputs
- 20a-20i: Memory chips
- 22: PLL unit
- 24: PLL feedback loop
- 26: Clock lines
- 28: Memory chip clock input
- 50a, 50b, 50c: Module circuit boards
- 52a-52i: Backside chips
- 60: First PLL unit
- 62: Second PLL unit
- 64: First feedback loop
- 66: Second feedback loop
- 70: Clock traces
- TL1: First transmission line
- R1: Termination resistor
- CLKin: PLL Clock input
- CLKout: PLL Clock output
- FBin: Feedback loop input
- FBout: Feedback loop output
- TL2: Second transmission line
- TL3: Third transmission line
- TL4: Fourth transmission line
- 80: Branching point
- C: Capacitor
- 90: Feedback loop
- TL1a: First portion of first transmission line
- TL1b: Second portions of first transmission line
- 92: Branching point
- 90a: Common portion of feedback loop
- 90b: First feedback loop branch
- 90c: Second feedback loop branch
- 94: Branching point
- TL5, TL6: Transmission lines
- 100: Indication arrow
- 102: Shared feedback loop
- 104: Line
- 102a: Common feedback loop portion
- 102b: First feedback loop branch
- 102c: Second feedback loop branch
- 106: Branching point
- C_{M1}, C_{M2}: Matching capacitors

## Claims

1. A memory module comprising:
a circuit board (50a; 50b; 50c);
multiple memory chips (20a to 20e, 52a to 52e) on the circuit board;
at least one clock input (12a, 12b) on the circuit board for receiving an external clock signal;
a first PLL unit (60) on the circuit board for providing an internal clock signal based on the external clock signal to a first set of at least one of the memory chips; and
a second PLL unit (62) on the circuit board for providing an internal clock signal based on the external clock signal to a second set of at least one of the memory chips,
**characterised in that** the second set and the first set are mutually exclusive.

2. The memory module according to claim 1, wherein each of the PLL units (60, 62) has a PLL clock input (CLKin) and wherein the PLL clock input of the first PLL unit is connected to a first clock input (12a), and the PLL clock input of the second PLL unit is connected to a second clock input (12b) on the circuit board (50a).

3. The memory module according to claim 1, wherein each of the PLL units (60, 62) has a PLL clock input (CLKin) and wherein the PLL clock inputs of the PLL units are connected to the same clock input (12a) on the circuit board (50b, 50c).

4. The memory module according to one of claims 1 to 3, wherein each of the PLL units (60, 62) has associated therewith a feedback loop (64, 66; 90; 102) designed to show a behavior similar to the behavior of a clock signal path between one of the PLL units (60, 62) and one of the memory chips, wherein the frequency of the internal clock signal is controlled based on a comparison of the external clock signal received at a PLL clock input (CLKin) of the PLL units (60, 62) and the internal clock signal transmitted over the feedback loop.

5. The memory module according to one of claims 1 to 3, wherein both PLL units (60, 62) share a common feedback loop (90; 102) in that a common portion (90a; 102a) of the feedback loop is connected to a feedback loop output (Fbout) of the first PLL unit (60) and that the common portion (90a; 120a) branches into two feedback loop branches (90b, 90c; 102b, 102c), wherein one of the feedback loop branches (90b; 102b) is connected to a feedback loop input (Fbin) of the first PLL unit (60) and the other of the feedback loop branches (90c; 102c) is connected to a feedback loop input (Fbin) of the second PLL unit (62).

6. The memory module according to claim 5, wherein the common portion (90a; 102a) branches into multiple feedback loop branches and wherein the number of the plurality of feedback loop branches corresponds to the number of memory chips connected to each PLL clock output (CLKout) of each PLL unit (60, 62).

## Patentansprüche

1. Ein Speichermodul mit folgenden Merkmalen:
einer Schaltungsplatine (50a; 50b; 50c);
mehreren Speicherchips (20a bis 20e, 52a bis 52e) auf der Schaltungsplatine;
zumindest einem Takteingang (12a, 12b) auf der Schaltungsplatine zum Empfangen eines externen Taktsignals;
einer ersten PLL-Einheit (60) auf der Schaltungsplatine zum Bereitstellen eines internen Taktsignals basierend auf dem externen Taktsignal an einen ersten Satz zumindest eines der Speicherchips; und
einer zweiten PLL-Einheit (62) auf der Schaltungsplatine zum Bereitstellen eines internen Taktsignals basierend auf dem externen Taktsignal an einen zweiten Satz zumindest eines der Speicherchips,
**dadurch gekennzeichnet, dass** der zweite Satz und der erste Satz sich gegenseitig ausschließen.

2. Das Speichermodul gemäß Anspruch 1, bei dem jede der PLL-Einheiten (60, 62) einen PLL-Takteingang (CLKin) aufweist, und bei dem der PLL-Takteingang der ersten PLL-Einheit mit einem ersten Takteingang (12a) verbunden ist und der PLL-Takteingang der zweiten PLL-Einheit mit einem zweiten Takteingang (12b) auf der Schaltungsplatine (50a) verbunden ist.

3. Das Speichermodul gemäß Anspruch 1, bei dem jede der PLL-Einheiten (60, 62) einen PLL-Takteingang (CLKin) aufweist, und bei dem die PLL-Takteingänge der PLL-Einheiten mit dem gleichen Takteingang (12a) auf der Schaltungsplatine (50b, 50c) verbunden sind.

4. Das Speichermodul gemäß einem der Ansprüche 1 bis 3, bei dem jeder der PLL-Einheiten (60, 62) eine Rückkopplungsschleife (64, 66; 90; 102) zugeordnet ist, die entworfen ist, um ein Verhalten zu zeigen, das dem Verhalten eines Taktsignalpfads zwischen einer der PLL-Einheiten (60, 62) und einem der Speicherchips ähnelt, wobei die Frequenz des internen Taktsignals basierend auf einem Vergleich des externen Taktsignals, das an einem PLL-Takteingang (CLKin) der PLL-Einheiten (60, 62) empfangen wird, und des internen Taktsignals, das über die Rückkopplungsschleife übertragen wird, gesteuert wird.

5. Das Speichermodul gemäß einem der Ansprüche 1 bis 3, bei dem beide PLL-Einheiten (60, 62) eine gemeinsame Rückkopplungsschleife (90; 102) gemeinschaftlich verwenden, dahingehend, dass ein gemeinsamer Abschnitt (90a; 102a) der Rückkopplungsschleife mit einem Rückkopplungsschleifenausgang (Fbout) der ersten PLL-Einheit (60) verbunden ist, und dass der gemeinsame Abschnitt (90a; 120a) sich in zwei Rückkopplungsschleifenzweige (90b, 90c; 102b, 102c) verzweigt, wobei einer der Rückkopplungsschleifenzweige (90b; 102b) mit einem Rückkopplungsschleifeneingang (Fbin) der ersten PLL-Einheit (60) verbunden ist und der andere der Rückkopplungsschleifenzweige (90c; 102c) mit einem Rückkopplungsschleifeneingang (Fbin) der zweiten PLL-Einheit (62) verbunden ist.

6. Das Speichermodul gemäß Anspruch 5, bei dem der gemeinsame Abschnitt (90a; 102a) sich in mehrere Rückkopplungsschleifenzweige verzweigt, und bei dem die Anzahl der Mehrzahl von Rückkopplungsschleifenzweigen der Anzahl von Speicherchips entspricht, die mit jedem PLL-Taktausgang (CLKout) jeder PLL-Einheit (60, 62) verbunden sind.

## Revendications

1. Module de mémoire, comprenant :
une plaquette de circuit (50a ; 50b ; 50c);
de multiples puces de mémoire (20a à 20e, 52a à 52e) sur la plaquette de circuit ;
au moins une entrée d'horloge (12a, 12b) sur la plaquette de circuit, destinée à recevoir un signal d'horloge externe ;
une première unité PLL (60) sur la plaquette de circuit, destinée à fournir un signal d'horloge interne sur base du signal d'horloge externe à un premier ensemble d'au moins l'une des puces de mémoire ; et
une deuxième unité PLL (62) sur la plaquette de circuit, destinée à fournir un signal d'horloge interne sur base du signal d'horloge externe à un deuxième ensemble d'au moins l'une des puces de mémoire,
**caractérisé par le fait que** le deuxième ensemble et le premier ensemble sont mutuellement exclusifs.

2. Module de mémoire selon la revendication 1, dans lequel chacune des unités PLL (60, 62) présente une entrée d'horloge PLL (CLKin) et dans lequel l'entrée d'horloge PLL de la première unité PLL est reliée à une première entrée d'horloge (12a), et l'entrée d'horloge PLL de la deuxième unité PLL est reliée à une deuxième entrée d'horloge (12b) sur la plaquette de circuit (50a).

3. Module de mémoire selon la revendication 1, dans lequel chacune des unités PLL (60, 62) présente une entrée d'horloge PLL (CLKin) et dans lequel les entrées d'horloge PLL des unités PLL sont reliées à la même entrée d'horloge (12a) sur la plaquette de circuit (50b, 50c).

4. Module de mémoire selon l'une des revendications 1 à 3, dans lequel chacune des unités PLL (60, 62) présente, y associée, une boucle de rétroaction (64, 66 ; 90 ; 102) conçue de manière à présenter un comportement similaire au comportement d'un trajet de signal d'horloge entre l'une des unités PLL (60, 62) et l'une des puces de mémoire, dans lequel la fréquence du signal d'horloge interne est contrôlée sur base d'une comparaison entre le signal d'horloge externe reçu à une entrée d'horloge PLL (CLKin) des unités PLL (60, 62) et le signal d'horloge interne transmis par l'intermédiaire de la boucle de rétroaction.

5. Module de mémoire selon l'une des revendications 1 à 3, dans lequel les deux unités PLL (60, 62) partagent une boucle de rétroaction commune (90 ; 102) en ce qu'une partie commune (90a ; 102a) de la boucle de rétroaction est reliée à une sortie de boucle de rétroaction (Fbout) de la première unité PLL (60) et que la partie commune (90a ; 120a) se divise en deux branches de boucle de rétroaction (90b, 90c ; 102b, 102c), dans lequel l'une des branches de boucle de rétroaction (90b ; 102b) est reliée à une entrée de boucle de rétroaction (Fbin) de la première unité PLL (60) et l'autre des branches de boucle de rétroaction (90c ; 102c) est reliée à une entrée de boucle de rétroaction (Fbin) de la deuxième unité PLL (62).

6. Module de mémoire selon la revendication 5, dans lequel la partie commune (90a ; 102a) se divise en de multiples branches de boucle de rétroaction et dans lequel le nombre de la pluralité de branches de boucle de rétroaction correspond au nombre de puces de mémoire reliées à chaque sortie d'horloge PLL (CLKout) de chaque unité PLL (60, 62).
